# EUROPEAN PATENT APPLICATION

(11) **EP 1 158 305 A1**
(43) Date of publication of application: **28.11.2001**
(21) Application number: 00201715.0
(22) Date of filing: 15.05.2000
(51) Int. Cl.: G01R 31/3185

(54) **System integrated on a chip of semiconductor material**

(71) Applicant: BULL S.A., 78434 Louveciennes Cedex (FR)
(72) Inventor: Bosisio, Giuseppe, 20099 Sesto San Giovanni (Milano) (IT); Zanzottera, Daniele, 20020 Busto Garolfo (Milano) (IT)
(74) Representative: Maccalli, Marco

(57) **Abstract**

A system (110) integrated on a chip of semiconductor material including a plurality of internal functional blocks (BL1-3; BL1,1-7; BL1,5,1-3) organised in a hierarchical structure having a plurality of levels, the blocks of each level being connected therebetween for exchanging internal signals (INT0-3; INT1,0-7; INT1,5,0) ; the integrated system (110) includes logic means (215,220; MUX0;MUX1;MUX1,5) for selecting one of the levels and for outputting at least part of the internal signals exchanged between the blocks of the selected level.

## Description

The present invention relates to a system integrated on a chip of semiconductor material.

Systems integrated on a chip of semiconductor material (also known as systems on chip) are widely used in several applications, such as in data-processing systems. The systems on chip have a very complex structure, with many internal functional blocks which exchange internal signals therebetween (for example some hundreds of blocks and some thousands of internal signals).

As a consequence, the debugging of a system on chip is a very difficult task. Typically, when an error occurs (both during a test phase or when the system on chip is operative), the functionality of the system on chip is reproduced in a simulation environment; the simulated operation of the system on chip is tested by inputting series of irritators and checking the corresponding output values, in order to understand the cause of the error.

A known solution for supporting the debugging of the system on chip consists, after the error occurs, in scanning the content of internal registers of the system on chip. However, this solution provides only a static state of the system on chip after the error occurred, and does not allow any analysis of transient phenomena to be carried out.

It is an object of the present invention to overcome the above mentioned drawbacks. This object is achieved by means of a system integrated on a chip of semiconductor material as set out in the first claim.

Briefly, the present invention provides a system integrated on a chip of semiconductor material including a plurality of internal functional blocks organised in a hierarchical structure having a plurality of levels, the blocks of each level being connected therebetween for exchanging internal signals; the integrated system includes logic means for selecting one of the levels and for outputting at least part of the internal signals exchanged between the blocks of the selected level.

Moreover, the present invention also provides a data-processing system including this integrated system and a corresponding method of debugging the integrated system.

Further features and the advantages of the system integrated on a chip of semiconductor material according to the present invention will appear in the following description of a preferred embodiment thereof, given purely by way of a non-restrictive indication, with reference to the attached drawings, in which:
Figure 1 is a basic block diagram of a data-processing system in which the integrated system of the present invention can be used,
Figure 2 shows the structure of the integrated system,
Figures 3 and 4 depict in more detail the structure of internal functional blocks of the integrated system.

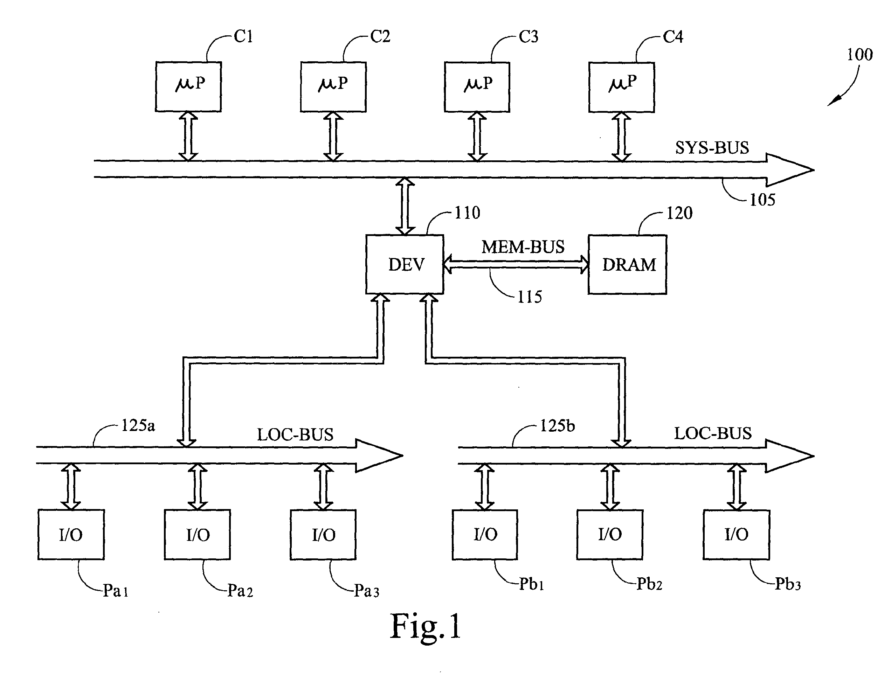

With reference in particular to Figure 1, there is shown a data-processing system 100 with several microprocessors (µp) C1, C2, C3 and C4 (four in the example at issue). The microprocessors C1-C4 are connected to a system bus (SYS_BUS) 105; particularly, the system bus 105 is constituted by a single address/command portion (to which all the microprocessors C1-C4 are connected in parallel) and two distinct data portions (to which the microprocessors C1,C2 and the microprocessors C3,C4 are connected, respectively).

A device (DEV) 110, integrated on a chip of semiconductor material (system on chip), is connected to the system bus 105; the system on chip 110 arbitrates a mutually exclusive access to the address portion of the system bus 105. The system on chip 110 is also connected, by means of a memory bus (MEM_BUS) 115, to a working memory 120, typically constituted by a DRAM (Dynamic Random Access Memory); the system on chip 110 controls the working memory 120 and operates as a cross-bar for exchanging data between the microprocessors C1-C4 and the working memory 120. Moreover, the system on chip 110 interfaces the system bus 105 with two local buses (LOC_BUS) 125a and 125b of the PCI (Peripheral Component Interconnect) type. Several peripheral input/output units (I/O) Pa1,Pa2,Pa3 and Pb1,Pb2,Pb3 are connected to the local bus 125a and to the local bus 125b, respectively, forming a corresponding cluster (of three peripheral units in the example at issue).

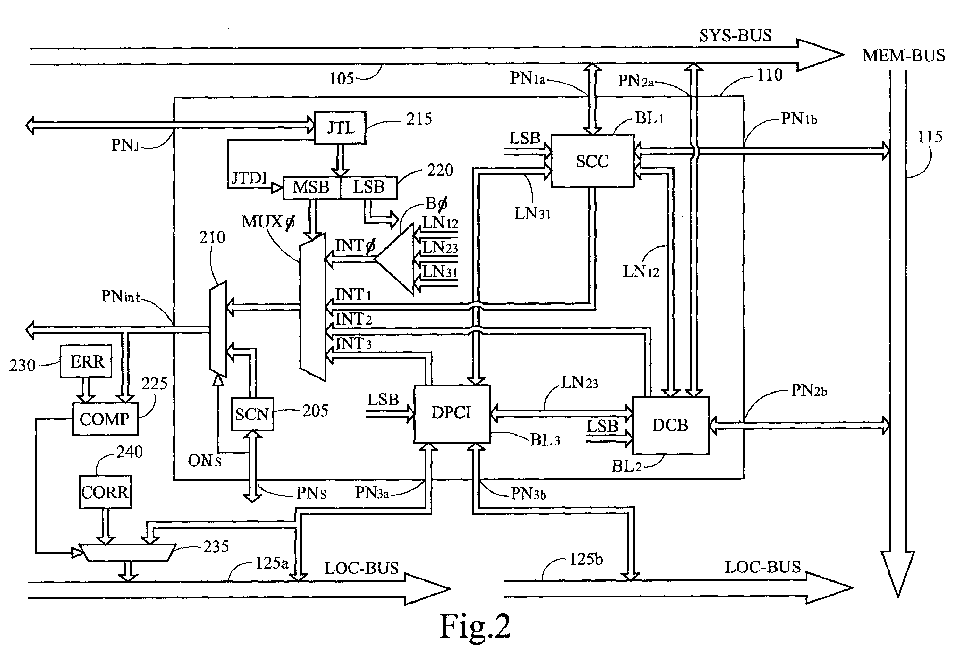

Considering now Fig.2, the system on chip 110 includes several internal functional blocks, which are organised in a hierarchical structure having two or more levels, such as some hundreds of blocks structured in a tree with three levels (in addition to a root level defined by the system on chip 110 itself). In the example depicted in the figure, three blocks BL1, BL2 and BL3 are provided at a first level of the tree. Particularly, the block BL1 (SCC) is a system controller (which arbitrates the access to the address portion of the system bus 105 and controls the working memory), the block BL2 (DCB) is a data-cross bar (which selectively interconnects the memory bus 115 and each data portion of the system bus 105, for allowing data to be exchanged between the microprocessors and the working memory), and the block BL3 (DPCI) is a dual bridge (which interfaces the system bus 105 with the two local buses 125a and 125b, managing the different communication protocols, timings, data and address formats, and arbitrates the access to each local bus 125a,125b).

Two sets of external pins PN1a and PN1b (each one constituted by a few hundreds of pins) are used to connect the block BL1 to the system bus 105 and to the memory bus 115, respectively. Likewise, two sets of pins PN2a and PN2b are used to connect the block BL2 to the system bus 105 and to the memory bus 115, respectively, and two sets of pins PN3a and PN3b are used to connect the block BL3 to the local bus 125a and to the local bus 125b, respectively.

A generic block BLi (with i=1..3) is connected to a different block BLj (with j=1..3 and j<>i) by means of a set of internal lines LNij (constituted for example by a few hundreds of lines); internal signals, normally not available outside the chip on which the system 110 is integrated, are exchanged between the blocks BL1-BL3 by means of the respective lines LN12-LN31.

As described in the following, each block BL1-BL3 includes further blocks connected therebetween by means of further lines, and in turn each of these further blocks includes still further blocks connected therebetween by means of still further lines.

Likewise. considerations apply if the system on chip is used in another application, if it has a different functionality, if it has a different structure, for example with a different number of blocks and levels (even structured in a not balanced tree), if it has a different number of external pins or internal lines, and so on.

In the system on chip according to the present invention, as described in detail in the following, it is possible to select one of the levels and output at least part of the internal signals exchanged between the blocks of the selected level.

The solution of the invention makes it possible to monitor the internal signals, allowing a dynamic analysis of the system on chip to be carried out. Therefore, transient phenomena can be directly studied in the system on chip.

This structure enables the different blocks of the system on chip to be singularly tested, leading to a top-down approach in the debugging of the system on chip; consequently, the identification of the block (or blocks) causing an error is highly simplified.

Moreover, in the solution according to the present invention, only a few internal signals (associated with the selected level) are output at a time. This allows the internal signals to be traced without significantly increasing the size of a package in which the chip is encapsulated.

In the particular embodiment shown in the figure, the system on chip 110 includes a buffer B0, which operates as an impedance separator amplifier. The buffer B0 has three inputs (each one constituted by a few terminals, for example 11) which are connected to some of the lines of the sets LN12, LN23 and LN31, respectively. The buffer B0 has an output which provides the most significant internal signals exchanged between the blocks BL1-BL3, denoted as a whole with INTO. The output of the buffer B0 is connected to a corresponding input of a multiplexer MUX0. The multiplexer MUX0 has three further inputs (each one constituted by 11 terminals) which are connected to the blocks BL1, BL2 and BL3, respectively; these inputs are supplied with some of the internal signals exchanged between the blocks subordinate to the respective block BL1, BL2 and BL3, denoted as a whole with INT1, INT2 and INT3, respectively.

A further internal block (SCN) 205 is used to scan, in a static manner, the content of internal registers of the system on chip 110 (not shown in the figure). A set of pins PNs connects the scan block 205 to the outside of the system on chip 110, such as to an external test unit (not shown in the figure). A multiplexer 210 has two inputs (each one constituted by 11 terminals) connected to the output of the multiplexer MUX0 and to an output of the scan block 205, respectively. One pin of the set PNs, to which an activation signal ONs of the scan block 205 is provided, is also connected to a control input of the multiplexer 210. A set of pins PNint (11 pins in the example at issue) are used to connect the output of the multiplexer 210 to the outside of the system on chip 110 (such as to the external test unit).

The system on chip 110 is also provided with a serial test interface of the JTAG (Joint Test Access Group) type. The JTAG interface includes a control logic (JTL) 215 for a shift register 220 (constituted by several binary cells, for example 7). The control logic 215 is connected to the outside of the system on chip 110 (such as to the external test unit) by means of five pins, denoted as whole with PNj. Particularly, these pins are used to input a serial data signal JTDI, an activation signal JTTMS, a reset signal JTRST, and a clock signal JTCLK (distinct from a general clock signal of the system on chip 110), and to output a serial data signal JTDO. The input signal JTDI is also provided to a serial input of the shift register 220. The five least significant bits stored in the shift register 220 (denoted with LSB) are supplied in parallel to each block BL1-BL3, while the two most significant bits stored in the shift register 220 (denoted with MSB) control the multiplexer MUX0.

A comparator 225 is provided outside the system on chip 110. The comparator 225 has an input connected to the pins PNint; a further input of the comparator 225 is connected to a register 230, wherein an error value ERR is stored. An output of the comparator 225 is provided to a control input of a multiplexer 235. The multiplexer 235 has an input connected to some of the pins PN3a; a further input of the multiplexer 235 receives a correction value CORR stored in a register 240. An output of the multiplexer 235 is connected to the local bus 125a (instead of the corresponding pins of the set PN3a).

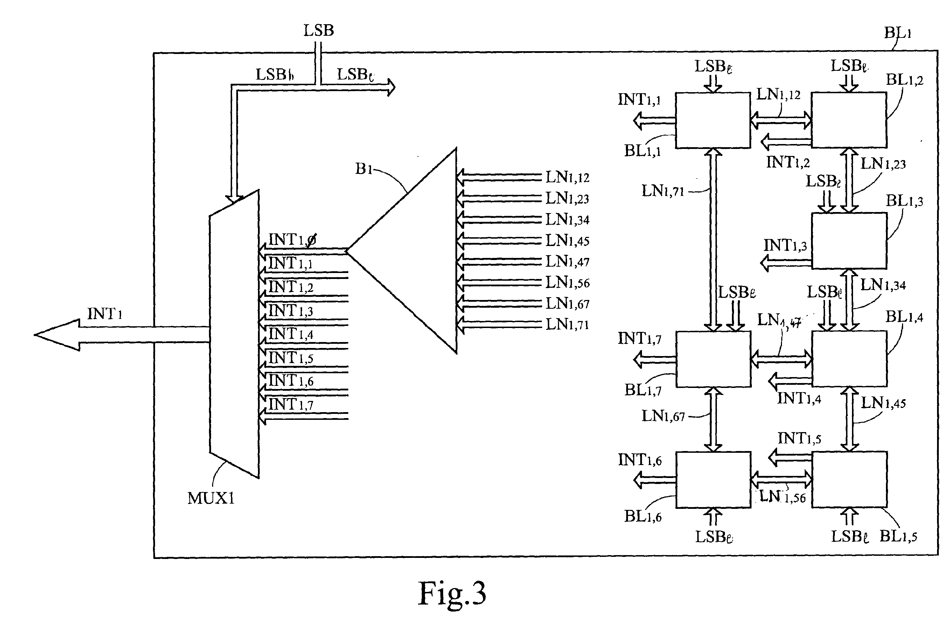

With reference now to Fig.3, there is depicted in more detail the structure of the block BL1 (likewise considerations apply in respect of the blocks BL2-BL3). The block BL1 includes seven blocks BL1,k (with k=1..7) subordinate thereto (the connections of these blocks to the outside of the block BL1 have been omitted for the sake of simplicity). A generic block BL1,k is connected to a different block BL1,1 (with 1=1..7 and l<>k) by means of a set of internal lines LN1,kl (for exchanging respective internal signals).

A buffer B1 has a plurality of inputs, each one connected to some of the lines of a corresponding set LN1,kl. The buffer B1 has an output which provides the most significant internal signals exchanged between the blocks BL1,1-BL1,7, denoted as a whole with INT1,0. The output of the buffer B1 is connected to a corresponding input of a multiplexer MUX1. The multiplexer MUX1 has seven further inputs, each one connected to a corresponding block BL1,k for receiving some of the internal signals exchanged between the blocks subordinate thereto, denoted as a whole with INT1,k. An output of the multiplexer MUX1 provides the internal signals INT1 outside the block BL1. The two least significant bits of the signal LSB (denoted with LSBl) are supplied in parallel to each block BL1,1-BL1,7, while the three most significant bits of the signal LSB (denoted with LSBh) control the multiplexer MUX1.

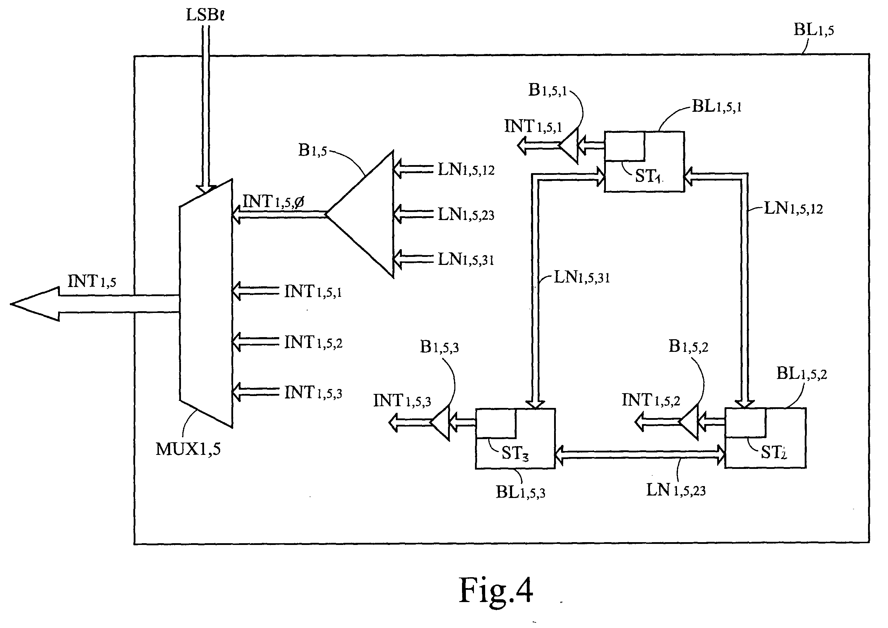

Similarly, as shown in Fig.4, the block BL1,5 (likewise considerations apply in respect of the blocks BL1,1-BL1,4 and BL1,6-BL1,7) includes three blocks BL1,5,u (with u=1..3) subordinate thereto (the connections of these blocks to the outside of the block BL1,5 have been omitted for the sake of simplicity). Each block BL1,5,u, which forms a leaf node of the hierarchical structure of the system on chip, is a basic block defining a primitive function of the system on chip. A generic basic block BL1,5,u is connected to a different basic block BL1,5,v (with v=1..3 and v<>u) by means of a set of internal lines LN1,5,uv (for exchanging respective internal signals). A buffer B1,5 has a plurality of inputs, each one connected to some of the lines of a corresponding set LN1,5,uv. The buffer B1,5 has an output which provides the most significant internal signals exchanged between the basic blocks BL1,5,1-BL1,5,3, denoted as a whole with INT1,5,0. The output of the buffer B1,5 is connected to a corresponding input of a multiplexer MUX1,5. Each basic block BL1,5,u includes a respective element STu which stores internal signals defining an operative status of the basic block BL1,5,u; for example, the storage element STu consists of flip-flops holding vectors of a state machine, commands, and the like. The multiplexer MUX1,5 has three further inputs, each one connected to a corresponding basic block BL1,5,u for receiving, through a respective buffer B1,5,u, some of the internal status signals of the basic block BL1,5,u, denoted as a whole with INT1,5,u. An output of the multiplexer MUX1,5 provides the internal signals INT1,5 outside the block BL1,5.

Referring back to Fig.2, the control logic 215 is switched on at a start-up of the system on chip 110, by asserting the activation signal JTTMS. The input signal JTDI is strobed with each rising edge of the clock signal JTCLK. Therefore, with a burst of pulses of the clock signal JTCLK, the string of bits LSB,MSB is serially loaded into the shift register 220.

The signal MSB controls the multiplexer MUX0. When the signal MSB has the value 00, the multiplexer MUX0 transfers to its output the internal signals INT0 exchanged between the blocks BL1-BL3 (irrespective of the value of the signal LSB). When the signal MSB has a value different from 00 (01-11), the multiplexer MUX0 transfers to its output the internal signals INT1-INT3 exchanged between the blocks subordinate to the block BL1-BL3 selected by the signal MSB.

For instance, if the signal MSB has the value 01 the multiplexer MUX0 transfers to its output the internal signals INT1. With reference to Fig.3, if the signal LSBh has the value 000, the multiplexer MUX1 transfers to its output the internal signals INT1,0 exchanged between the blocks BL1,1-BL1,7, which define the internal signals INT1 (irrespective of the value of the signal LSBl). If the signal LSBh has a value different from 000 (001-111), the multiplexer MUX1 transfers to its output the internal signals INT1,1-INT1,7 corresponding to the block BL1,1-BL1,7 selected by the signal LSBh.

For example, if the signal LSBh has the value 101 the multiplexer MUX1 transfers to its output the internal signals INT1,5. With reference to Fig.4, if the signal LSBl has the value 00, the multiplexer MUX1,5 transfers to its output the internal signals INT1,5,0 exchanged between the basic blocks BL1,5,1-BL1,5,3 (which define the internal signal INT1,5). If the signal LSBl has a value different from 00 (01-11), the multiplexer MUX1,5 transfers to its output the internal status signals INT1,5,1-INT1,5,3 of the basic block BL1,5,1-BL1,5,3 selected by the signal LSBl.

Referring again to Fig.2, the internal signals transferred to the output of the multiplexer MUX0 are input to the multiplexer 210. During a normal operation of the system on chip 110, the scan block 205 is switched off (activation signal ONs deasserted); therefore, the multiplexer 210 transfers these internal signals to the pins PNint, so that they are available outside the system on chip 110.

Conversely, when an error occurs in the system on chip 110, the operation of the system on chip 110 is aborted. The external test unit then switches on the scan block 205 by asserting the activation signal ONs. Consequently, the multiplexer 210 transfers the output of the scan block 205 to the pins PNint; this permits to dump the content of the internal registers of the system on chip 110 (which is used to perform a static analysis of the system on chip 110 after the error occurred).

The structure described above is very simple and flexible. Particularly, this solution allows three different levels of the hierarchical structure of the system on chip 110 to be selected, with up to three blocks at the first level, up to seven blocks at a second level, and up to three basic blocks at the last third level.

In addition, the possibility of selecting the internal status signals of each basic block is particularly advantageous. In fact, once the basic block causing the error has been identified, the operation of this block can be directly traced.

Moreover, the buffers connected between the internal lines (or the storage elements of the basic blocks) and the pins PNint enable the internal signals to be output without perturbing in any way the operation of the system on chip 110; this feature greatly increases the reliability of any test performed on the system on chip 110.

The JTAG interface 215,220, used to select the level of the hierarchical structure, is particularly advantageous since it exploits components and pins already available in the system on chip 110. Therefore, this feature does not increase in any way the complexity and size of the system on chip 110.

In addition, the pins PNint are multiplexed between the structure outputting the internal signals and the scan block 205; this solution does not require any further pin specifically dedicated to the output of the internal signals.

Similar considerations apply if the set PNint is constituted by a different number of pins, if the multiplexers allow a different number of levels and a different number of blocks in each level to be selected, if a further multiplexer is used to select the internal status signals of each basic block to be output, if the buffers are disposed in another position or are replaced by equivalent means; likewise, the shift register is constituted by a different number of binary cells and the string of bits loaded therein is split into a different number of sub-sets (each one formed by a different number of bits), a different serial test interface is used, the pins PNint are multiplexed with another service block (which is inactive during the normal operation of the system on chip), and so on. Alternatively, the system on chip has a different structure (even without any buffer and without the possibility of outputting the internal status signals of the basic blocks), the level is selected by dedicated pins (allowing a faster selection, with the drawback of increasing the complexity and size of the system on chip), the level is selected in a static manner when the system on chip is not operative, or the pins PNint are dedicated to output the internal signals.

In a preferred embodiment of the present invention, the internal signals output by the pins PNint are also used to modify the operation of the system on chip 110. Let us suppose that in some circumstances one or more of the signals output by the pins PN3a assume a wrong value; for example, a grant signal supplied on a dedicated line to every peripheral unit connected to the local bus 125a assumes as a whole the wrong value 110, instead of a correct value 010. The system on chip 110 is debugged, using the facilities provided by the present invention, applying input signals to the set of pins PN1a-PN3b and analysing the corresponding value of different internal signals of the system on chip 110 (selected by means of the JTAG interface 215,210). In this manner, it is found out that the error occurs when the internal signals exchanged between the blocks subordinate to the block BL1, which are selected by the string of bits 0100000 stored in the shift register 220, assume the value 00011010110.

The string of bits 0100000 is loaded into the shift register 220 (by means of the JTAG interface 215,220); the error value ERR=00011010110 and the correction value CORR=010 are stored in the register 230 and in the register 240, respectively. During the normal operation of the system on chip 110, the internal signals (corresponding to the level selected by the string of bits stored in the shift register 220) are continuously compared with the error value ERR stored in the register 230. If the internal signals differ from the error value ERR, the output of the comparator 225 is deasserted; consequently, the multiplexer 235 transfers to its output the signals supplied by the pins PN3a, which are then provided to the local bus 125a. In this situation, the components 225-240 do not interfere in any way with the operation of the system on chip 110. Conversely, if the internal signals match the error value ERR, the output of the comparator 225 is asserted; consequently, the multiplexer 235 transfers to its output the correction value CORR stored in the register 240. This correction value CORR is then supplied to the local bus 125a, replacing the wrong value provided by the pins PN3a.

The above described structure permits to correct some kind of errors in the system on chip 110 without reworking the device (even if the size and the response time of the system on chip 110 is slightly increased). Moreover, this solution makes it possible to test any fix to be applied to the system on chip 110 in advance (before a new system on chip is produced).

Likewise considerations apply if one or more different operative signals output by the system on chip are corrected, if the comparator is connected only to some of the pins PNint or if different external correction components are used (such as a sequential network), and so on. However, the system on chip of the present invention lends itself to be implemented even without any external correction component.

Naturally, in order to satisfy local and specific requirements, a person skilled in the art may apply to the system integrated on a chip of semiconductor material described above many modifications and alterations all of which, however, are included within the scope of protection of the invention as defined by the following claims.

## Claims

1. A system (110) integrated on a chip of semiconductor material including a plurality of internal functional blocks (BL1-3; BL1,1-7; BL1,5,1-3) organised in a hierarchical structure having a plurality of levels, the blocks of each level being connected therebetween for exchanging internal signals (INT0-3; INT1,0-7; INT1,5,0),
**characterised in that**
the integrated system (110) includes logic means (215,220; MUX0;MUX1;MUX1,5) for selecting one of the levels and for outputting at least part of the internal signals exchanged between the blocks of the selected level.

2. The system (110) according to claim 1, wherein each basic block (BL1,5,1-3) defining a leaf node of the hierarchical structure includes means (ST1-3) for storing internal status signals (INT1,5,1-3) of the basic block, the logic means further comprising means (MUX1,5) for selecting one of the basic blocks (BL1,5,1-3) and for outputting at least part of the internal status signals of the selected basic block.

3. The system (110) according to claim 2, wherein the logic means includes, for each level of the hierarchical structure, a multiplexer (MUX0,MUX1,MUX1,5) having an input for receiving at least part of the internal signals (INT0; INT1,0; INT1,5,0) exchanged between the blocks of the corresponding level and, for each block of the corresponding level, an input for receiving at least part of the internal signals (INT1-3; INT1,1-7) exchanged between the blocks subordinate to the block of the corresponding level if the block of the corresponding level is not a basic block or at least part of the internal status signals (INT1,5,1-3) of the block of the corresponding level if the block of the corresponding level is a basic block.

4. The system (110) according to claim 3, wherein the logic means includes a serial test interface (215,220) for controlling the multiplexers (MUX0;MUX1;MUX1,5).

5. The system (110) according to claim 4, wherein the serial test interface (215,220) includes a shift register (220) and means (215) for serially loading a string of bits into the shift register (220), the string of bits including a plurality of sub-sets of bits (MSB;LSBh;LSBl) each provided to a control input of a corresponding multiplexer (MUX0;MUX1;MUX1,5).

6. The system (110) according to any claim from 2 to 5, wherein the chip has a plurality of external pins (PNint) at which the output internal signals are available, the integrated system (110) including a plurality of internal lines (LN12-31; LN1,12-71; LN1,5,12-31) for exchanging the internal signals and buffer means (B0; B1; B1,5; B1,5,1-3) connecting the internal lines (LN12-31; LN1,12-71; LN1,5,12-31) and the storing means (ST1-3) to the external pins (PNint).

7. The system (110) according to claim 6, further including a service block (205), the service block (205) being inactive during a normal operation of the integrated system (110), and means (210) for selectively connecting the logic means (MUX0) or the service block (205) to the external pins (PNint).

8. The system (110) according to any claim from 1 to 7, further including external means (225-240) connected to the external pins (PNint) for comparing at least part of the output internal signals with an error value producing a wrong value of at least one operative signal output by the integrated system (110) and for modifying the at least one operative signal to a correction value in response to the result of the comparison.

9. A data processing system (100) including at least one integrated system (110) according to any claim from 1 to 8.

10. A method of debugging a system (110) integrated on a chip of semiconductor material including a plurality of internal functional blocks (BL1-3; BL1,1-7; BL1,5,1-3) organised in a hierarchical structure having a plurality of levels, the blocks of each level being connected therebetween for exchanging internal signals (INT0-3; INT1,0-7; INT1,5,0),
**characterised by** the steps of
selecting one of the levels, and
outputting at least part of the internal signals exchanged between the blocks of the selected level.
